# EUROPEAN PATENT APPLICATION

(11) **EP 1 530 366 A2**
(43) Date of publication of application: **11.05.2005**
(21) Application number: 04256790.9
(22) Date of filing: 03.11.2004
(51) Int. Cl.: H04N 5/225

(54) **An imaging apparatus and a method of manufacturing the imaging apparatus**

(30) Priority: 07.11.2003 JP 2003378090
(71) Applicant: Konica Minolta Opto, Inc., Hachioji-shi, Tokyo (JP)
(72) Inventor: Uesaka, Takeshi, Konica Minolta Opto, Inc., Tokyo, 192-8505 (JP)
(74) Representative: Rees, Alexander Ellison

(57) **Abstract**

An imaging apparatus comprising: an imaging means including an imaging device converting electronic signal a subject light; an imaging optical means which has an optical element and an supporting frame for supporting the optical element, and which guides the subject light to the imaging device; and a housing means including a temporary fixing means for temporarily fixing the imaging optical means in the housing means.

## Description

### RELATED APPLICATION

This application is based on patent application No. 2003-378090 filed in Japan, the entire content of which is hereby incorporated by reference.

### BACKGROUND OF THE INVENTION

### 1. Field of the Invention

The present invention relates to an imaging apparatus, and particularly to an imaging apparatus which is appropriate for having built-in into a portable terminal, and a small sized and thin type, and whose focal point is adjustable corresponding to an objective distance, and an assembling method thereof.

### 2. Description of the Related Art

Conventionally, an imaging apparatus which is small sized and thin type, is mounted on a small sized thin type portable terminal such as a portable phone, or a PDA(Personal Digital Assistant). Hereby, not only the audio information but also the image information can be transferred each other to a remote place. As an imaging device used for these imaging apparatus, a solid imaging device such as a CCD (Charge Coupled Device) type image sensor or a CMOS (Complementary Metal-Oxide Semiconductor) type image sensor is used.

Recently, these imaging apparatus become such a condition that an imaging apparatus in which not a pan-focus photographing in which an imaging optical system is fixed and a deep depth of field is used, but the imaging optical system is moved, and a macro photographing can be conducted, comes also into the market.

As these imaging apparatus in which the macro-photographing can be conducted, a structure in which protrusions and skewed slots are mutually formed in a photographing lens and a cylindrical holder, and when the photographing lens is rotated, the photographing lens is moved in the optical direction, is adopted. As the imaging apparatus of such a structure, an apparatus by which the focus adjustment is conducted at the time of assembling, and further by using the skewed slot, a short range photographing can be conducted, is disclosed (for example, refer to Patent Document 1).

### (Patent Document 1) Tokkai No. 2002-82271

The portable terminal in which the above-described imaging apparatus is housed, particularly, the portable phone is rapidly increased recently, and following this, the demand of the small sized thin type imaging apparatus which can be housed in the portable phone, is also rapidly increased.

Such an imaging apparatus is very small one whose volume is not lager than 1 cm³, and in an assembly of manual operation by the operator, a very delicate handling is required, and an assembling cost becomes high. Further, in the assembling by the human power, it is also difficult to rapidly cope with the increase and decrease of the demand. Therefore, it is considered to intend the automation of assembly and by this automation, to flexibly cope with the increase and decrease of demand, at low cost.

On the one hand, in the imaging apparatus written in the above Patent Document 1, protrusions and skewed slots are mutually formed in the photographing lens and cylindrical holder. Then, at the time of assembling, it is necessary that these protrusions and skewed slots are engaged, and further, after that, the photographing lens is rotated so that they are not disengaged. Accordingly, there is a problem that it is not a structure that is suitable for the automation of the assembly.

Further, in a system in which the imaging optical system is guided by a guide shaft and moved in the optical axis direction, when a member engaged with the guide shaft which is fixed in a open-sided manner, is positioned and assembled, a very much delicacy is required. Accordingly, this is an obstacle of the automation of the assembly.

### SUMMARY OF THE INVENTION

The object of the present invention is to make the imaging apparatus a structure possible to cope with the automation of the assembly, and hereby, to obtain a low cast imaging apparatus which can flexibly cope with the increase and decrease of demand and can conduct a macro photographing.

Furthermore, the object of the present invention is to provide a method of assembling the imaging apparatus.

These and other objects are attained by an imaging apparatus comprising: an imaging means including an imaging device converting electronic signal a subject light; an imaging optical means which has an optical element and an supporting frame for supporting the optical element, and which guides the subject light to the imaging device; and a housing means including a temporary fixing means for temporarily fixing the imaging optical means in the housing means.

Further, the above object of the present invention is attained by an imaging apparatus comprising: an imaging means including an imaging device for converting electronic signal a subject light; an imaging optical means which has an optical element and an supporting frame for supporting the optical element, and which guides the subject light to the imaging device; a housing means including a temporary fixing means for temporarily fixing the imaging optical means in the housing means; and a positioning means for positioning the housing means and the imaging optical means.

Further, the above object of the present invention is attained by a method of manufacturing an imaging apparatus having an imaging optical means for guiding the subject light to an imaging means, an housing means and a cover member, the method comprising the steps of: the first process by which the imaging optical means is fitted and fixed to the imaging means; the second process by which, after the first process, the imaging optical means is temporarily fixed to the housing means; the third process by which, after the second process, the imaging optical means temporarily fixed in housing means is covered by the cover means; and the fourth process by which, after the third process, the housing means and the imaging optical means are positioned by the positioning means.

The invention itself, together with further objects and attendant advantages, will best be understood by reference to the following detailed description taken in conjunction with the accompanying drawings.

### BRIEF DESCRIPTION OF THE DRAWINGS

Fig. 1 is an external appearance view of a portable phone T which is an example of a portable terminal provided with an imaging apparatus of the present invention.
Fig. 2 is a perspective view of an imaging apparatus 100 according to the first embodiment.
Fig. 3 is a sectional view in the direction parallel to the optical axis of the imaging apparatus 100 according to the present invention.
Fig. 4 is a view in which an inside of the imaging apparatus 100 is viewed from the optical axis direction.
Fig. 5 is the inside of the imaging apparatus 100, and a sectional view of a periphery of a positioning means.
Fig. 6 is a view showing an assembling order of the imaging apparatus 100 according to the present invention.
Fig. 7 is a sectional view of the direction parallel to the optical axis of an imaging apparatus 150 according to the second embodiment.

In the following description, like parts are designated by like reference numbers throughout the several drawings.

### DESCRIPTION OF THE PREFERRED EMBODIMENT

By the embodiments, the present invention will be detailed below, however, the present invention is not limited to this.

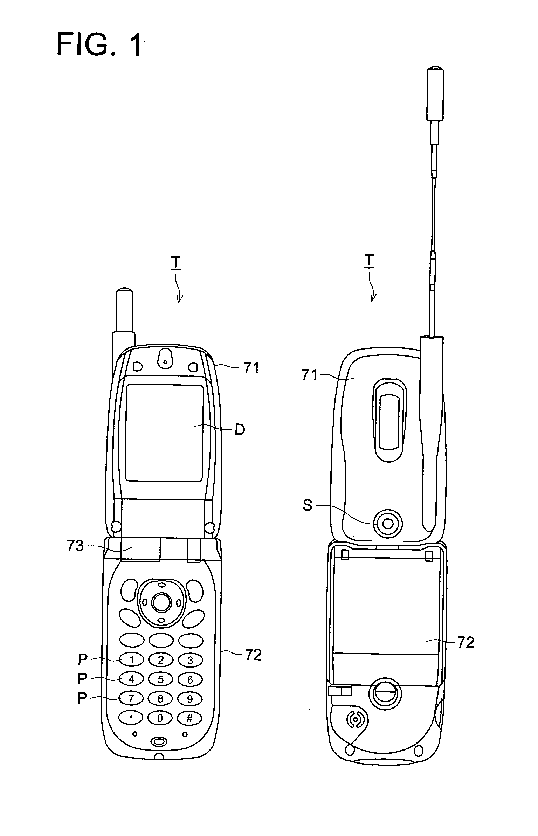

Fig. 1 is an external appearance view of a portable phone T which is an example of a portable terminal provided with an imaging apparatus of the present invention. In the portable phone T shown in this view, an upper housing 71 as a case provided with a display image plane D is jointed with a lower housing 72 provided with operation buttons P through a hinge 73. The imaging apparatus S in the phone is housed below the display image plane D of the upper housing 71, and is arranged so that a subject light can be taken in from the outer surface side of the upper housing 71. Hereupon, a position of this imaging apparatus S in the phone may also be arranged above the display image plane D in the upper housing 71. Further, the portable phone is not limited to a collapsible type one.

### 1. The first embodiment

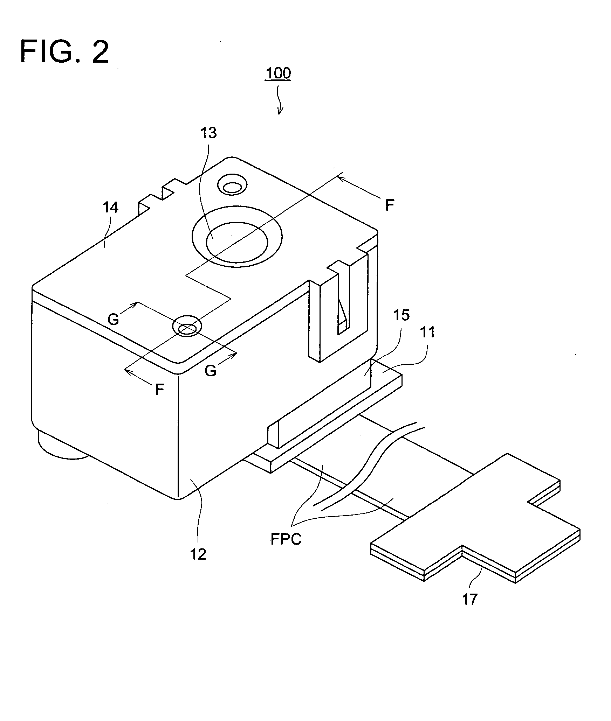

Fig. 2 is a perspective view of an imaging apparatus 100 according to the first embodiment. This imaging apparatus 100 is housed in a position of an imaging apparatus S in a phone shown in Fig. 1.

As shown in Fig. 2, the imaging apparatus 100 is composed of a circuit board 11 on which the imaging device is mounted, a base member 15, an outer frame member 12, and a cover member 14 which is assembled on the upper surface of this outer frame member 12, and has an aperture section 13 on which the subject light is incident. An housing means which will be described later, in the inside is composed of the outer frame member 12 and the cover member 14. A connector section 17 for connecting the imaging apparatus 100 to other substrate of the portable terminal, and a flexible printed circuit FPC for connecting this circuit board 11 to the connector section 17 are connected.

An inside of the imaging apparatus 100 will be described below. Hereupon, in the following drawings, for preventing the overlapping of the description, the same member will be described with the same reference.

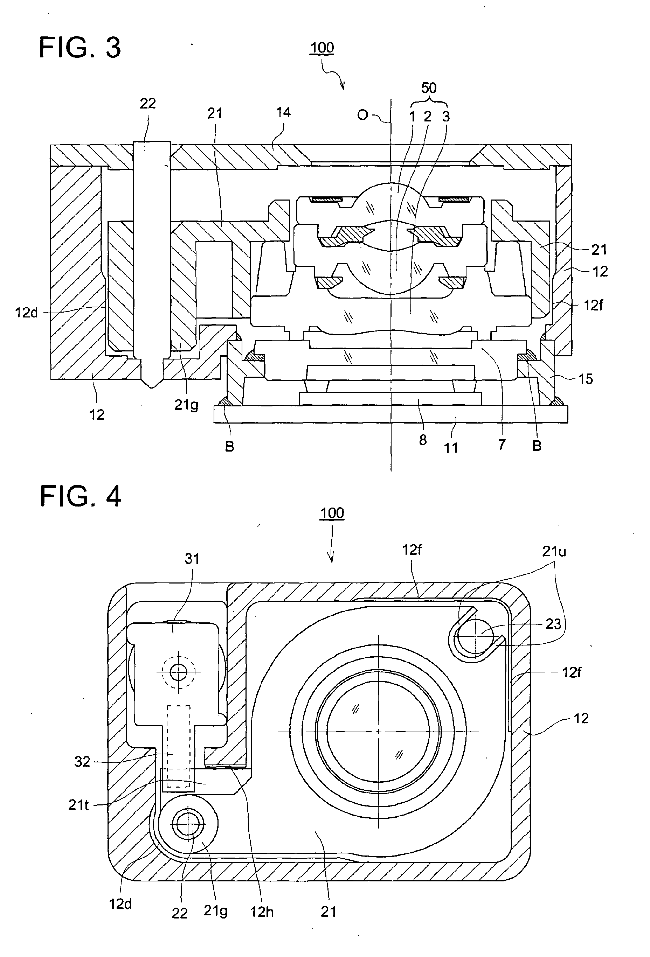

Fig. 3 is a view showing a cross section in which the imaging apparatus 100 according to the present invention is cut on F-F line shown in Fig. 2.

In the same view, 1 is the first lens, 2 is the second lens and 3 is the third lens, and they are optical elements having the optical performance. 21 is an supporting frame. The first lens 1, second lens 2, third lens 3, and aperture means are previously unitized. The supporting frame 21 holds an imaging optical system 50 comprising the first lens 1, second lens 2, third lens 3, and aperture means and these are previously unitized. The imaging optical means is composed of these imaging optical system 50, supporting frame 21, and aperture means. O is an optical axis.

8 is an imaging device. 7 is a table which is structured by a shielding means for shielding the infrared light, and on which the imaging device 8 is positioned. The table 7 is molded by a material for shielding the infrared light, or a translucent material, and an infrared ray cut coating is provided on the subject light transmission surface. The circumference of the base member 15 is adhered and fixed to the circuit board 11 by an adhesion bond B, and in the table 7, its circumference is adhered to this base member 15 by an adhesion bond B, and the table 7 seals a space in which the imaging device 8 exists. Therefore, dusts hardly stick to the imaging device 8, and it becomes possible to prevent that dusts are reflected on the photographed image. The imaging means is structured by the circuit board 11 integrally structured with these imaging devices 8, or the table 7.

22 is a positioning guide shaft as a positioning means. As shown in the same view, in the supporting frame 21, a guide cylinder 21g engaged with a positioning guide shaft 22 held by the outer frame member 12 and the cover member 14, and a U-shaped engagement section engaged with another guide shaft which is not shown, are integrally formed. Hereby, the supporting frame 21 holding the imaging optical system 50 is structured in such a manner that it can straightly move in the optical axis O direction along the positioning guide shaft 22.

The outer frame member 12 is adhered and fixed to the base member after it is assembled on the base member 15. For temporarily fixing the imaging optical means, on a part of the inner periphery of the outer member 12, guide sections 12d, 12f are provided. The guide sections 12d, 12f are structured in such a manner that they reduce a space between the supporting frame 21 and the outer frame member 12.

Fig. 4 is a view in which the inside of the imaging apparatus 100 is viewed from the optical axis direction.
This is a view of a condition that the cover member 14 of the imaging apparatus 100 is taken off.

As shown in the same view, in the supporting frame 21, the guide cylinder 21g engaged with the positioning guide shaft 22, and the U-shaped engagement section 21u engaged with the other guide shaft 23 are integrally formed.
Further, on the inner wall of the outer frame member 12 in the vicinity of this guide cylinder 21g, the guide sections 12d, and 12h structured by reducing the gap, are provided, and on the inner wall of the outer frame member 12 in the vicinity of the engagement section 21u, the guide sections 12f structured by reducing the gap is provided.

Hereby, when the supporting frame 21 is placed in the outer frame 12, a part of side surface of the supporting frame 21 is guided by the guide sections 12d, 12h, 12f, and is placed on a corresponding position in the outer frame member 12. According to this, a temporary position of the supporting frame 21 in the outer frame member 12 is determined. These guide sections 12d, 12h, and 12f are temporary fixing means for temporarily fixing the imaging optical means. Further, the guide sections 12d and 12h, 12f are, as shown in Fig. 3, formed in such a manner that a gap is small on the imaging device 8 side of the outer frame member 12, and a gap is large on the subject side. When structured in such a manner, the supporting frame 21 is easily assembled in the outer frame member 12, and as the supporting frame 21 is sunken inside, it is guided to a predetermined position, and the supporting frame 21 is easily positioned in a temporary position.

31 is an actuator for moving the supporting frame 21 in the optical axis direction. When the actuator 31 drives the engagement section 32 engaged with an arm section 21t formed in the supporting frame 21 in the optical axis direction, the supporting frame 21, that is, the imaging optical system 50 is moved in the optical axis direction. When the imaging optical system 50 is moved in the optical axis direction, the imaging optical system 50 is set in the over-focus position, or the macro photographing position. As this actuator 31, a stepping motor, DC motor, or piezoelectric element is applied.

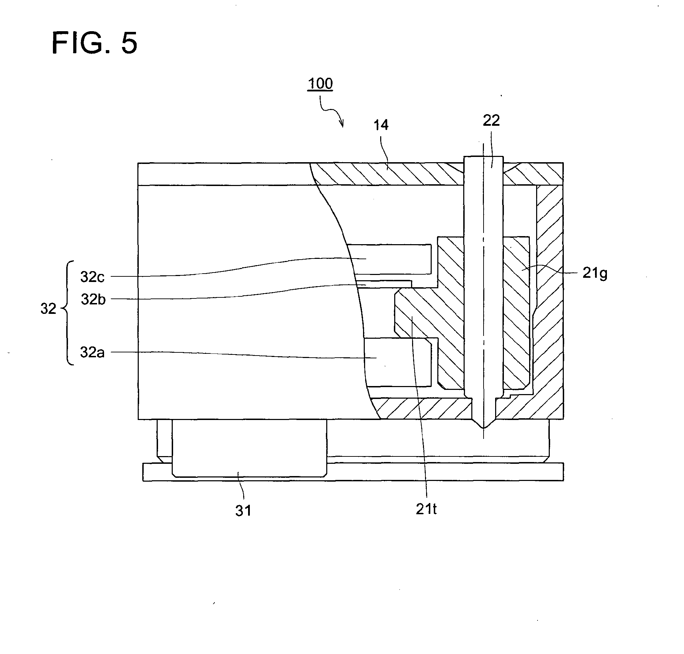

Fig. 5 is a sectional view of a periphery of the positioning guide shaft 22 of the imaging apparatus 100. The same view is a view showing a cross section in which the imaging apparatus 100 is cut on G-G line shown in Fig. 2.

As shown in the same view, in the guide cylinder 21g engaged with the positioning guide shaft 22, the arm section 21t is formed, and this arm section 21t is engaged with the engagement section 32 driven in the optical axis direction by the actuator 31. The engagement section 32 has members 32a and 32c formed of rigid bodies and a member 32b formed of a plate material having the spring property. The arm section 21t is nipped with the member 32a formed of the rigid body, and the plate material 32b having the spring property. This is for the reason that, even when the supporting frame 21 is brought into contact with a member of the imaging device side, the actuator 31 does not lock it, and when the plate material 32b having the spring property is bent, the absorption of over-stroke is conducted.

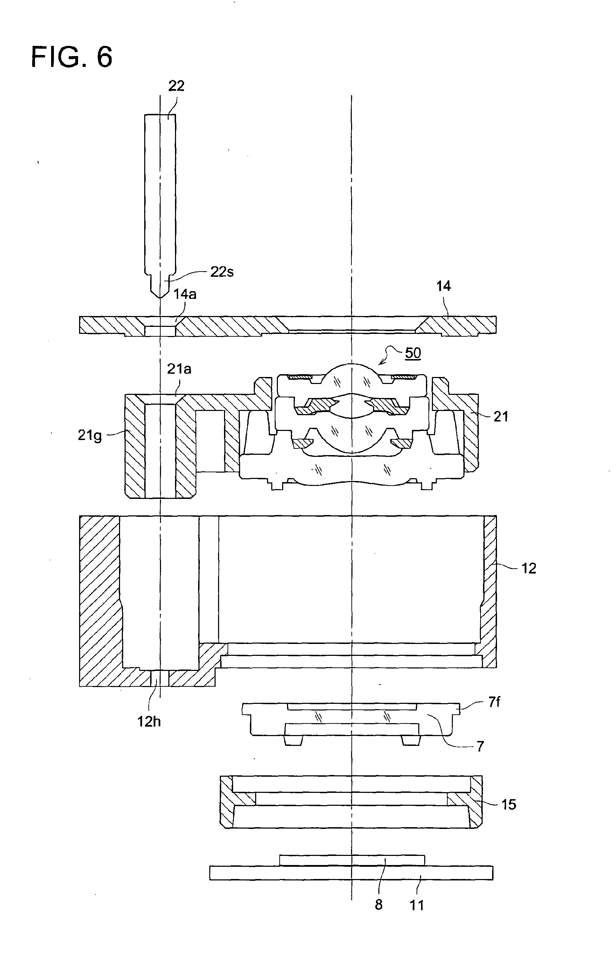

Fig. 6 is a view showing an assembling order of the imaging apparatus 100 according to the present invention. It will be described below following the assembling process. Hereupon, after the assembling, it becomes a condition of Fig. 3.
(1) After the base member 15 is placed on the circuit board 11 on which the imaging device 8 is mounted, the base member 15 is adhered and fixed. In more detail, the position of the imaging device 8 mounted on the circuit board 11 is confirmed by a TV camera provided on a tool, and the base member 15 is placed so that a position to the imaging device 8 is a predetermined position. After that, the entire outer peripheral parts are adhered to and fixed on the circuit board 11 by using, for example, ultraviolet ray hardening type adhesion bond.
(2) After the table 7 is inserted from above the base member 15 and placed, the entire periphery of a flange section 7f of the table 7 is adhered. Hereby, the space of the imaging device 8 on the circuit board 11 is sealed, the entrance of moisture can be prevented.
(3) After the outer frame member 12 is placed on the base member 15, it is adhered and fixed.
(4) The supporting frame 21 supporting the imaging optical system 50 which is unitized, is previously placed in the outer frame member 12. In this case, as described in Fig. 3 and Fig. 4, the supporting frame 21 is positioned at a predetermined temporary position in the outer frame member 12.
(5) After the cover member 14 is placed on the outer frame member 12, it is adhered and fixed.
(6) The positioning guide shaft 22 and the guide shaft 23 (refer to Fig. 4) are assembled. While a leading edge portion 22s of the positioning guide shaft 22 is guided by a countersinking portion 14a of the cover member 14 and a countersinking portion 21a of the guide cylinder 21g of the supporting frame 21, it penetrates the cover member 14 and the guide cylinder 21g, and a tapered leading edge portion 22s of the positioning guide shaft 22 is inserted into a hole 12h formed in the outer frame member 12. After that, at the countersinking portion 14a of the cover member 14, the positioning guide shaft 22 is adhered and fixed. In the same manner, the guide shaft 23 penetrates also the cover member 14, and is inserted into a hole formed in the outer frame member 12 through a U-shaped engagement section 21u (refer to Fig. 4). After that, at the countersinking portion 14a of the cover member 14, the guide shaft 23 is adhered and fixed.
   Hereby, the supporting frame 21 is positioned at a normal position of the outer frame member 12, and the movement in the optical axis direction along the positioning guide shaft 22 can be conducted.
(7) The actuator 31 and the engagement section 32 are assembled.

In the above assembling method, a method in which, after a part is placed, it is adhered and fixed, is described. However, when the adhesion bond has the viscosity, the adhesion bond is applied to it previously, and after that, each part may also be placed so that the position is determined.

### 2. The second embodiment

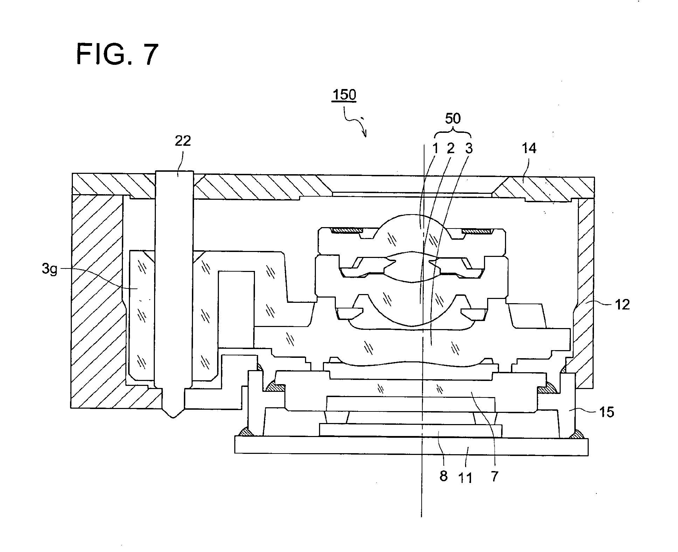

Fig. 7 is a sectional view of an imaging optical system section of an imaging apparatus 150 according to the second embodiment. In the imaging apparatus 150 shown in the same view, the external appearance is the same as the imaging apparatus shown in Fig. 2, and the cross section cut on F-F line in the same manner, is shown. In the imaging apparatus 150 shown in the same view, an supporting frame for supporting the imaging optical system is formed of a part of the third lens 3 constituting the imaging optical system. For avoiding the overlapping of the description, the same signs are given to the same members, and they will be described.

In the same view, in the imaging apparatus 150, the guide cylinder 3g engaged with the positioning guide shaft 22 integrally with the third lens 3, is integrally formed. Further, in this third lens 3, the second lens 2, first lens 1, and stops arranged in each lens, are assembled, and it is structured as the unitized imaging optical system 50.

Further, in the third lens 3, the surface shape viewed from the optical axis direction is, in the same manner as the supporting frame 21 shown in Fig. 4, a shape in which the u-shaped engagement section engaged with the guide shaft 23 is also integrally formed.

Hereby, when the third lens 3, that is, the imaging optical system 50 is placed in the outer frame member 12, the third lens 3 is positioned at a predetermined position in the outer frame member 12. By this structure, the assembling can be conducted in the same procedure as the assembling order described in Fig. 6. For the other parts, they are the same as the structure of the imaging optical system 100 shown in Fig. 3.

### EFFECTS OF THE INVENTION

As described above, according to the first embodiment, when the supporting frame 21 is placed in the outer frame member 12, because at least one part of the supporting frame 21 is guided by a guide section provided in the outer frame member 12, a temporary position of the supporting frame 21 in the outer frame member 12 is easily determined. Then, after the supporting frame 21, cover member 14 are placed in the outer frame member 12, when the positioning guide shaft is only inserted in to a hole formed in the cover member 14, the supporting frame 21 can be positioned at a normal position. Accordingly, the guide member can be rapidly assembled, and comparing to a method by which the guide cylinder and cover member are assembled adjusting to the open-sided guide shaft, which is a conventional problem, the delicacy at the time of assembling can be made unnecessary, and the imaging apparatus in which an automatic assembly is easily made, and a macro photographing can be conducted, and its manufacturing method can be obtained.

Hereupon, for an example in which the outside surface of the imaging apparatus is separated into the base member and the outer frame member, description is made, however, it is of course that the base member and the outer frame member are integrated, and it may also be placed and fixed on the circuit board.

Further, an example in which the guide section is formed on the inner wall surface of the outer frame member, is described, however, it is not limited to this, and it is of course that an example in which the guide section is independently formed inside the outer frame member, is not also out of the scope of the present invention.

Further, according to the second example, the imaging apparatus in which an automatic assembly is easily made, and a macro photographing can be conducted, is obtained. Furthermore, a cost reduction by the reduction of the number of parts can be conducted, the intercalated parts are abolished by the integration of a part of the imaging optical system with the guide cylinder, and the degree of parallelization of the optical axis of the imaging optical system to the hole section of the guide cylinder can be improved. Accordingly, the solid body dispersion of the image obtained by the imaging apparatus can be decreased.

Hereupon, in the above imaging apparatus 100, 150, for the purpose to put the backlash of the drive system to one side, as an energizing member, a compression coil spring may also be arranged between the guide cylinder 21g or 3g and the cover member 14. Further, for cutting the infrared ray, a table in which it is molded by a material to cut the infrared ray, or by a translucent material, and the infrared ray cut coating is applied on the subject light transmission surface, is described, however, it is not limited to this, it is of course that the infrared ray cut filter may be adhered and fixed to the base member.

It is to be noted that various changes and modifications will be apparent to those skilled in the art. Therefore, unless such changes and modifications depart from the scope of the present invention, they should be construed as being included therein.

## Claims

1. An imaging apparatus comprising:
(a) an imaging means including an imaging device converting electronic signal a subject light;
(b) an imaging optical means which has an optical element and an supporting frame for supporting the optical element, and which guides the subject light to the imaging device; and
(c) a housing means including a temporary fixing means for temporarily fixing the imaging optical means in the housing means.

2. An imaging apparatus according to claim 1, wherein the imaging means includes a circuit board on which the imaging device is mounted.

3. An imaging apparatus according to claim 1, wherein a part of the optical element have a function of the supporting frame.

4. An imaging apparatus according to claim 1, wherein the housing means has an aperture section and a cover member for closing the aperture section.

5. An imaging apparatus comprising:
(a) an imaging means including an imaging device for converting electronic signal a subject light;
(b) an imaging optical means which has an optical element and an supporting frame for supporting the optical element, and which guides the subject light to the imaging device;
(c) a housing means including a temporary fixing means for temporarily fixing the imaging optical means in the housing means;
(d) and a positioning means for positioning the housing means and the imaging optical means.

6. An imaging apparatus according to claim 5, wherein the imaging means includes a circuit board on which the imaging device is mounted.

7. An imaging apparatus according to claim 5, wherein the imaging means includes a circuit board on which the imaging device is mounted and shielding means for shielding the infrared light.

8. An imaging apparatus according to claim 5, wherein a part of the optical element have a function of the supporting frame.

9. An imaging apparatus according to claim 5, wherein the housing means has an aperture section and a cover member for closing the aperture.

10. An imaging apparatus according to claim 5, wherein the positioning means positions the housing means and the imaging optical means.

11. An imaging apparatus according to claim 5, wherein the positioning means positions the cover member and the imaging optical means.

12. An imaging apparatus according to claim 5, wherein the positioning member positions the housing means, the cover member, and the imaging optical means.

13. A method of manufacturing an imaging apparatus having an imaging optical means for guiding the subject light to an imaging means, an housing means and a cover member, the method comprising the steps of:
(a) the first process by which the imaging optical means is fitted and fixed to the imaging means;
(b) the second process by which, after the first process, the imaging optical means is temporarily fixed to the housing means;
(c) the third process by which, after the second process, the imaging optical means temporarily fixed in housing means is covered by the cover means;
(d) and the fourth process by which, after the third process, the housing means and the imaging optical means are positioned by the positioning means.

14. A method of claim 13, wherein the imaging means includes a circuit board on which the imaging device is mounted.

15. An imaging apparatus according to claim 13, wherein the imaging means includes a circuit board on which the imaging device is mounted and shielding means for shielding the infrared light.

16. A method of claim 13, wherein the positioning means positions the housing means and the imaging optical means.

17. A method of claim 13, wherein the positioning means positions the cover member and imaging optical means.

18. A method of claim 13, wherein the positioning member positions the housing means, the cover member, and the imaging optical means.

19. A method of claim 13, wherein the imaging optical means has an optical element and the supporting frame for supporting the optical element.

20. A method of claim 19, wherein a part of the optical element have a function of the supporting frame.
